Europäisches Patentamt

European Patent Office

Office européen des brevets

(19)

(11) Veröffentlichungsnummer: **0 501 171 A2**

## (12) EUROPÄISCHE PATENTANMELDUNG

(21) Anmeldenummer: **92101711.7**

(22) Anmeldetag: **03.02.92**

(51) Int. Cl.5: **H05K 1/11**

(30) Priorität: **25.02.91 DE 9102204 U**

(43) Veröffentlichungstag der Anmeldung:
**02.09.92 Patentblatt 92/36**

(84) Benannte Vertragsstaaten:
**AT BE CH DE FR GB IT LI NL**

(71) Anmelder: **Siemens Nixdorf
Informationssysteme Aktiengesellschaft
Fürstenallee 7
W-4790 Paderborn(DE)**

(72) Erfinder: **Klimke, Peter, Dipl.-Ing.
Paul-Gerhardt-Allee 66
W-8000 München 60(DE)**

(74) Vertreter: **Fuchs, Franz-Josef, Dr.-Ing. et al
Postfach 22 13 17
W-8000 München 22(DE)**

(54) Kontaktvorrichtung zur Herstellung einer Andruckkontaktverbindung.

(57) Die Erfindung bezieht sich auf eine Kontaktvorrichtung zur Herstellung einer Andruckkontaktverbindung zwischen starren und flexiblen Leiterplatten. Zwischen zwei Leiterplatten, die mit höchstintegrierten Schaltkreisen bestückt sind, ist es notwendig, eine hochfrequenztaugliche und gasdichte Verbindung herzustellen. Diese muß einen kontrollierten Wellenwiderstand besitzen.

Die Erfindung sieht hierfür vor, daß die starren Leiterplatten (1,2) Kontaktflecken (7,8) und die flexiblen Leiterplatten (3) Kontaktfinger (11,12,13,14) als Kontaktstellen für die Leiterbahnen der Leiterplatten (1,2,3) aufweisen. Die Kontaktfinger (11,12,13,14) der flexiblen Leiterplatte (3) und die Kontaktflecken (7,8) der starren Leiterplatte (1,2) liegen aufeinander. Auf der nicht mit der Leiterbahn versehenen Rückseite der flexiblen Leiterplatte ist ein in einem Träger (28,29,31) abgestütztes Federband (26,35) angeordnet, dessen im Abstand der Konaktfinger (11,12,13,14) der flexiblen Leiterplatte (3) ausgeprägten Einzelfedern (23,25) Kontaktfinger (11,12,13,14) und Kontaktflecken (7,8) einzeln über die Isolationsschicht der flexiblen Leiterplatte mit Hilfe von die Gegenkraft aufnehmenden Elementen (32,34) gedrückt wird.

FIG 1

Die Erfindung bezieht sich auf eine Kontaktvorrichtung zur Herstellung einer Andruckkontaktverbindung zwischen starren und flexiblen Leiterplatten.

Aufgabe der vorliegenden Erfindung ist es, eine Kontaktvorrichtung zur Herstellung einer hochfrequenztauglichen und gasdichten Andruckkontaktverbindung zwischen starren mit höchstintegrierten Bausteinen bestückten und einer flexiblen Leiterplatte zu schaffen. Dabei sollen insbesondere zwei starre, Bauelemente tragende Leiterplatten elektrisch miteinander verbunden werden.

Zur Lösung dieser Aufgabe wird die Kontaktvorrichtung gemäß der Erfindung derart ausgebildet, daß die starren Leiterplatten Kontaktfinger als Kontaktstellen für die Leiterbahnen der Leiterplatten aufweisen, daß die Kontaktfinger der flexiblen Leiterplatte und die Kontaktflecken der starren Leiterplatte aufeinanderliegen, daß auf der Rückseite der flexiblen Leiterplatte ein in einem Träger abgestütztes Federband angeordnet ist, dessen im Abstand der Kontaktfinger der flexiblen Leiterplatte ausgeprägten Einzelfedern Kontaktfinger und Kontaktflekken einzeln über die Isolationsschicht der flexiblen Leiterplatte mit Hilfe von die Gegenkraft aufnehmenden Elementen aufeinanderdrücken.

Um eine einwandfreie Justierung der Kontaktfinger der flexiblen Leiterplatte mit den Kontaktflekken der starren Leiterplatten zu gewährleisten, enthalten die Leiterplatten und das Federband Paßlöcher zum Einführen von Paßstiften oder Paßschrauben.

Als gegenkraftaufbringendes Element können entweder Paßschrauben oder ein bremssattelähnlicher Bügel, der mit einer Schraube befestigt ist, verwendet werden.

Vorteilhafterweise kann die flexible Leiterplatte zweilagig ausgebildet sein, wobei die signal- und die massepotantialführenden Leiterbahnen der zweiten Lage über getrennte Durchkontaktierungen auf die erste Lage durchkontaktiert sind, wobei die signal- und massepotentialführenden Leiterbahnen der ersten Lage von den Durchkontaktierungen elektrisch getrennt sind. Die Federn des Federbandes können entweder trapezförmig ausgebildet sein, so daß sie ein zweireihiges Kontaktelement bilden oder das Federband ist kammförmig ausgestaltet, so daß es ein einreihiges Kontaktelement darstellt, dessen Federn schräg nach unten abgebogen sind.

Zwei derartige einreihige Federbänder können in einem Träger zu einem zweireihigen Kontaktelement vereinigt werden. Die Kontaktgabe zwischen den Kontaktfingern der flexiblen Leiterplatte und den Kontaktflecken der starren Leiterplatten kann dadurch erhöht werden, daß die Kontaktfinger der flexiblen Leiterplatte erhaben ausgebildet werden.

Durch diese Maßnahmen erhält man eine Kontaktvorrichtung mit einem konstanten Wellenwiderstand. Außerdem hat diese Kontaktvorrichtung nur wenige Kontaktstellen und damit nur eine geringe Anzahl von Stoßstellen, so daß möglichst wenig elektrische Störfaktoren auftreten. Die Kontaktvorrichtung kann an beiden Enden gelöst werden und erlaubt außerdem Drehbewegungen um einen festen Drehpunkt. Zudem ist eine hohe Packungsdichte wegen des kleinen Kontaktabstandes der mehrreihigen Kontaktanordnung sowie der niedrigen Bauhöhe gewährleistet. Sie genügt den an sie gestellten Hochfrequenzanforderungen (Signal GND Verhältnis 1:1). Auch Dicketoleranzen der Leiterplatten können mit dieser Kontaktvorrichtung in einfacher Weise ausgeglichen werden.

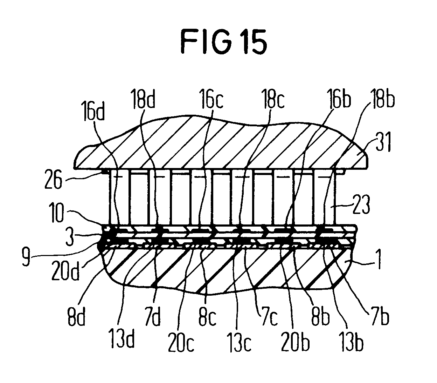

Anhand der Ausführungsbeispiele nach den FIG 1 bis 15 wird die Erfindung näher erläutert.

Es zeigen

FIG 1 einen teilweisen Querschnitt durch eine zwei starre Leiterplatten enthaltende Baugruppe mit einer flexiblen Schaltung als Verbindungselement,

FIG 2 eine Draufsicht auf eine starre Leiterplatte mit einem Ausschnitt eines Anschlußfeldes mit Kontaktflecken,

FIG 3 eine schematische Darstellung der beiden Lagen der flexiblen Leiterplatte in Draufsicht auf jede einzelne Lage,

FIG 4 einen Querschnitt durch eine zweilagige Leiterplatte nach FIG 3,

FIG 5 einen Längsschnitt durch eine Zweilagige Leiterplatte nach FIG 3 entlang einer massepotentialführenden Leiterbahn,

FIG 6 einen Längsschnitt durch eine zweilagige flexible Leiterplatte entlang einer signalpotentialführenden Leiterbahn,

FIG 7 ein einreihiges Federband,

FIG 8 ein zweireihiges Federband,

FIG 9 einen Querschnitt durch eine Kontaktfedereinheit mit zwei einreihigen Federbändern in der Federebene,

FIG 10 einen Querschnitt durch eine Kontaktfedereinheit mit zwei einreihigen Federbändern im Paßlochbereich,

FIG 11 einen Querschnitt durch eine Kontaktfedereinheit mit zweireihigem Federband in der Federebene,

FIG 12 einen Querschnitt einer Kontaktfedereinheit mit einem zweireihigen Federband im Paßlochbereich,

FIG 13 einen Querschnitt durch eine Kontaktfedereinheit mit einem zweireihigen Kontaktfederband und einem bremssattelähnlichen Bügel zur Auffangung der Gegenkräfte,

FIG 14 einen Querschnitt durch eine Kontaktfedereinheit nach FIG 13 im Paßlochbereich und

FIG 15 einen Teilquerschnitt durch eine Kontaktfedereinheit nach FIG 11 oder 13.

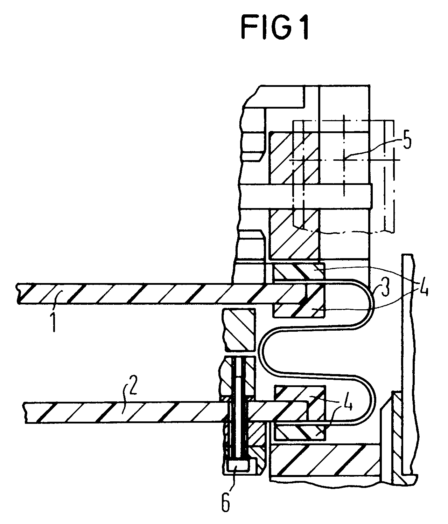

Die in FIG 1 dargestellte Baugruppe verwendet zur Verbindung zweier Leiterplatten 1, 2 eine flexible Leiterplatte 3, die mit Hilfe von Andruckverbindern 4 den Kontakt zwischen den beiden starren, mit Bauteilen bestückten Leiterplatten 1, 2 herstellt. Diese flexible Verbindung ermöglicht ein Aufklappen der beiden starren Leiterplatten 1, 2 um den Drehpunkt 5, der lediglich schematisch dargestellt ist.

Die Befestigung der starren Leiterplatte 2 mit dem Boden der Baugruppe erfolgt mit Hilfe der Schrauben 6.

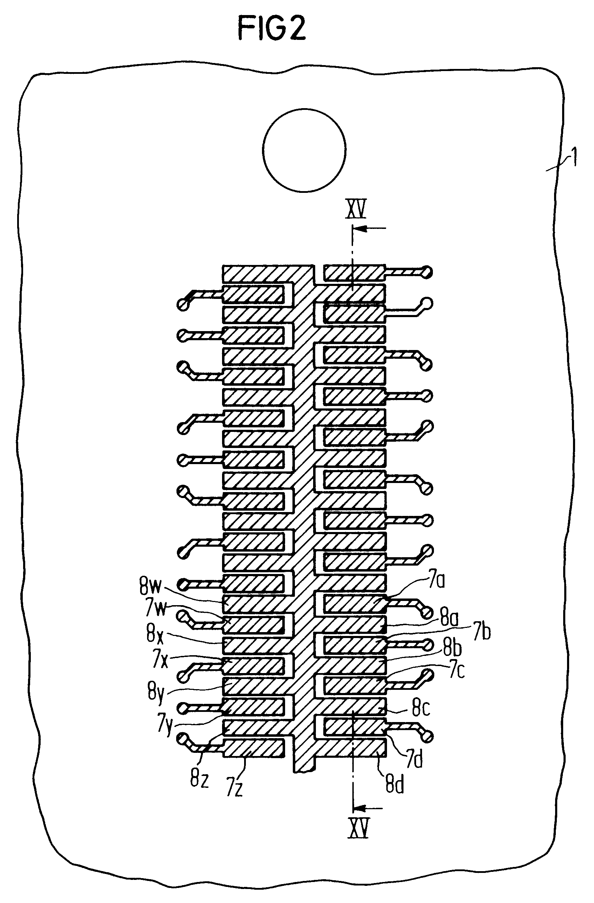

Die Kontaktierung der starren Leiterplatten 1, 2 erfolgt über auf der Oberfläche der Leiterplatten angeordnete Kontaktflecken 7, 8. Wie FIG 2 zeigt, sind dabei zwei Arten von Kontaktflecken vorhanden, wobei die ersten Kontaktflecken 7 die Verbindung zu den signalspannungführenden Leiterbahnen im Inneren der starren Leiterplatte herstellen, während die über einen Mittelstreifen miteinander verbundenen Kontaktflecken 8 die Verbindung mit den massepotentialführenden Leiterbahnen herstellen.

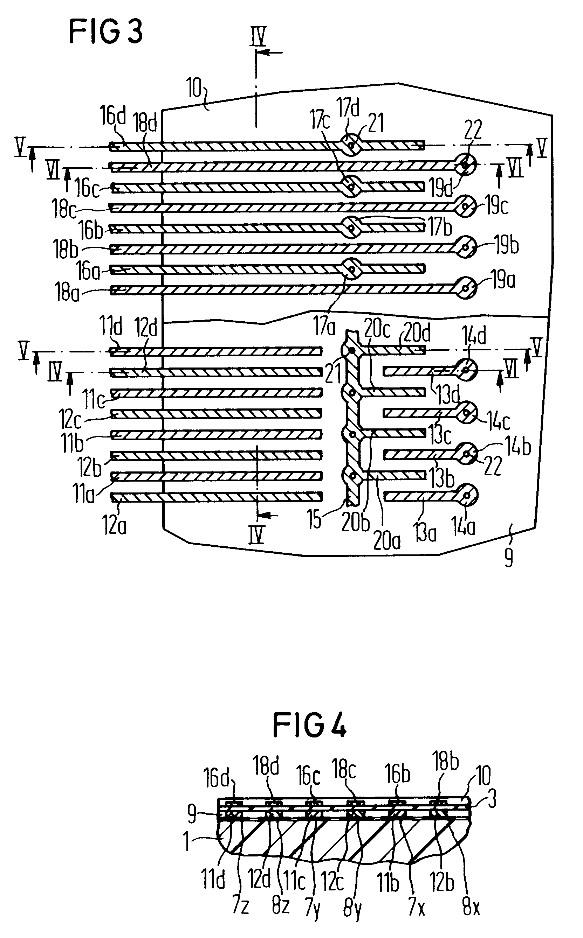

Die flexible Leiterplatte ist wie in FIG 3 gezeigt, zweilagig ausgebildet. Die beiden Lagen 9 und 10 sind zum besseren Verständnis nebeneinander abgebildet. Die obere Lage 10 enthält dabei abwechselnd von oben nach unten betrachtet, massepotentialführende Leiterbahnen 16 und signalpotenialführende Leiterbahnen 18. Die signalführenden Leiterbahnen 18 sind an ihrem vorderen Ende mit Lötaugen 19, in denen sich die Durchkontaktierungen 22 befinden, versehen. Die Durchkontaktierungen für die massepotentialführenden Leiterbahnen 16 hingegen sind gegenüber ihrem Leiterbahnende etwas nach hinten versetzt. Durch diese Anordnung ist es möglich, eine Durchkontaktierung beider mit unterschiedlichen Potentialen versehenen Leiterbahnen auf die erste Lage 9 in einfacher Weise durchzuführen.

Auf der Lage 1 sind entsprechend der Anordnung in der Lage 2 die Durchführungen sowohl für die signalführenden Leiterbahnen mit den dazugehörigen Lötaugen 14 und die Durchführungen für die massepotentialführenden Leiterbahnen 20 angeordnet, wobei letztere über eine Querverbindung 15 miteinander verbunden sind.

Die signalführenden Leiterbahnen 11 und die massepotentialführenden Leiterbahnen 12 in der ersten Lage 9 der flexiblen Leiterplatte 3 sind gegenüber den vorstehend genannten Durchkontaktierungen abgesetzt. Außerdem ist ihre Reihenfolge in umgekehrter Weise vorgenommen, als in der zweiten Lage 10.

Einen Querschnitt entlang der Schnittlinie IV in FIG 3 zeigt FIG 4, wobei in diesen Querschnitt jeweils nur sechs der acht Leiterbahnen nach FIG 3 dargestellt sind. In der Lage 1 sind dabei abwechselnd die signalführenden Leiterbahnen 11 und die massepotentialführenden Leiterbahnen 12 mit den Kontaktflecken 7 und 8 der starren Leiterplatten 1, 2 verbunden. Oberhalb der ersten Lage 9 ist die Anordnung der Leiterbahnen 16, 18 der Lage 10 dargestellt, die gegenüber den Leiterbahnen der Lage 9 jeweils genau um eine Leiterbahn versetzt angeordnet sind.

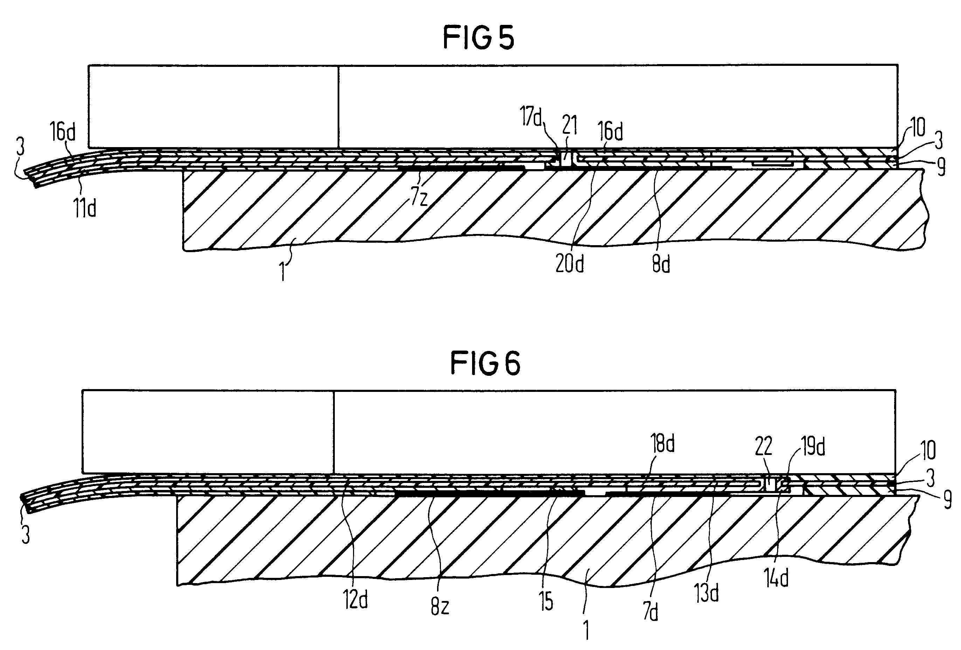

Der Schnitt V ist in FIG 5 dargestellt. Er ist entlang einer massepotentialführenden Leiterbahn 16d der zweiten Lage 10 bzw. der signalführenden Leiterbahn 11d der ersten Lage 9 gelegt. Aus FIG 5 ist die jeweilige Zuordnung zwischen den Kontaktflecken 7, 8 der starren Leiterplatte und den Leiterbahnen 13, 14 bzw. 11, 12 deutlich erkennbar. So liegt beispielsweise auf dem Kontaktflecken 8d, die massepotentialführende Leiterbahn 20d der ersten Lage 9 und darüber die ebenfalls massepotentialführende Leiterbahn 16d der zweiten Lage 10, wobei beide Lagen durch die Durchkontaktierung 21 miteinander verbunden sind. Der dem Kontaktflecken 8d gegenüberliegende Kontaktfleck 7z nach FIG 2 ist mit der signalpotentialführenden Leiterbahn 11d der ersten Lage 9 kontaktiert, während in der darüberliegenden zweiten Lage 10 der flexiblen Leiterplatte 3 die massepotentialführende Leiterbahn 16d liegt, die wiederum über die Durchkontaktierung 21 und dem Lötauge 17d mit dem Kontaktflecken 8d der starren Leiterplatte verbunden ist. Zwischen den einzelnen Leiterbahnen der ersten Lage 9 und der zweiten Lage 10 sind jeweils Isolationslagen angeordnet.

Der Schnitt VI in FIG 3 ist in FIG 6 dargestellt. Hier verläuft die Schnittlinie in der zweiten Lage 10 durch die signalführende Leiterbahn 18d und in der ersten Lage 9 durch die massepotentialführende Leiterbahn 12d. Der Kontaktflecken 7d auf der starren Leiterplatte nach FIG 2 ist hier mit der Leiterbahn 13d der ersten Lage 9 der flexiblen Schaltung verbunden und zugleich über die Durchkontaktierung 22 mit den dazugehörigen Lötaugen 14d der Lage 9 und 19d der zweiten Lage 10 mit der darüberliegenden Leiterbahn 18d. Der Kontaktflecken 8z der starren Leiterbahn ist mit der masseführenden Leiterbahn 12d der ersten Lage 9 der flexiblen Leiterplatte 3 verbunden, während der Verbindungssteg 15 der ersten Lage 9 der flexiblen Leiterplatte 3 zwischen der Leiterbahn 13d und 12d erkennbar ist.

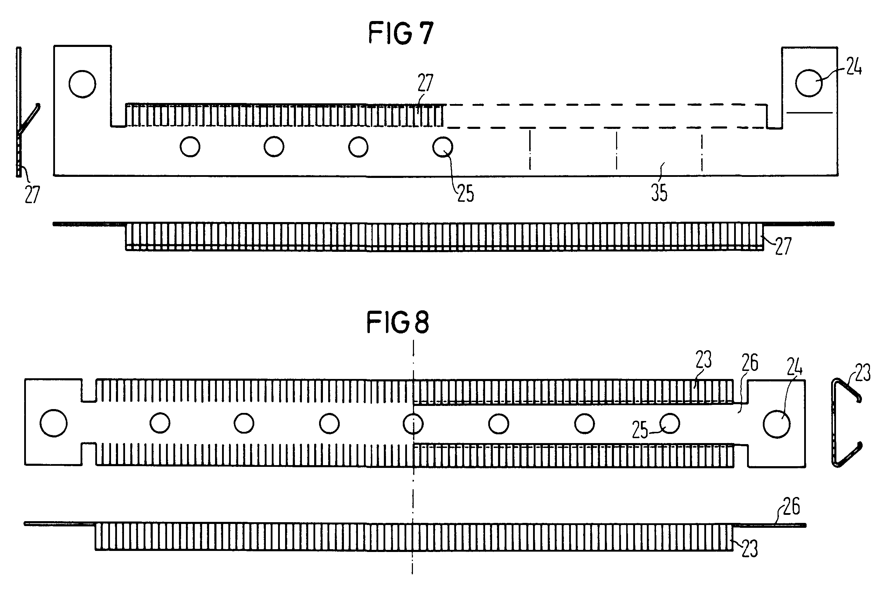

Ein bandförmig ausgebildetes einseitiges Federband 35 ist in FIG 7 gezeigt. Die Kontaktfedern 27 sind schräg nach unten abgebogen. In FIG 7 ist sowohl die Draufsicht als auch die Seitenansicht dargestellt.

Ein zweireihiges Federband 26 ist in FIG 8 dargestellt. Dabei ist die rechte Hälfte des Federbandes von unten und die linke Hälfte des Federbandes als Draufsicht gezeigt. Die einzelnen Federn 23 sind bei dieser Anordnung trapezförmig ausgebildet, wobei das Trapez nach unten offen ist. Das Federband enthält, wie das einreihige Federband nach FIG 7, Paßlöcher 24, durch die entweder Paßstifte oder Paßschrauben geführt werden können und in seinem Mittelsteg jeweils Befestigungslöcher 25 für Befestigungsschrauben.

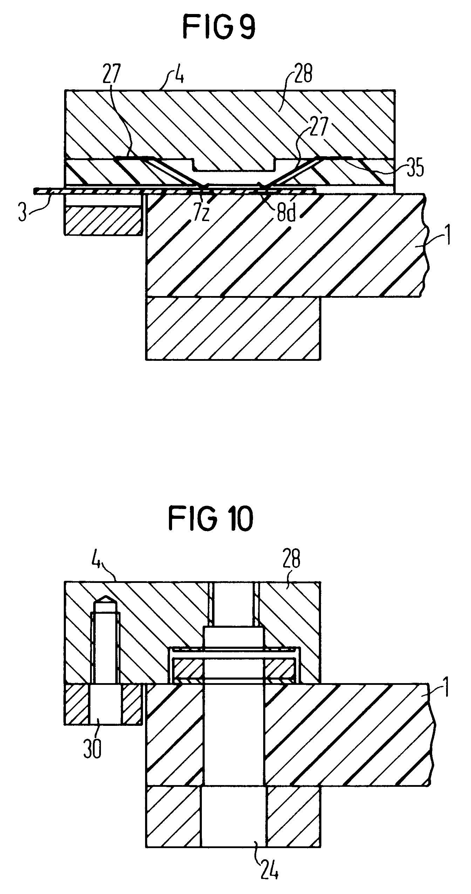

In Fig 9 ist ein Längsschnitt durch eine Kontaktfedereinheit, die aus zwei einreihigen Federbändern 35 besteht gezeigt, wobei die beiden einreihigen Federbänder 35 durch den Träger 28 vereinigt werden. Die Federn 27 sind, wie in FIG 8 dargelegt ausgebildet, die flexible Schaltung 3 liegt zwischen der Leiterplatte 1 und dem Federband 35, wobei im vorliegenden Fall die Kontaktflecken 7z und 8d der starren Leiterplatte nach FIG 2 als Querschnittsebene gewählt wurden. Der Querschnitt durch die Paßlöcherebene der gleichen Kontaktfedereinheit ist in FIG 10 dargestellt. In die Paßlöcher 24 können nicht dargestellte Paßschrauben eingedreht werden, die die Leiterplatte 1 mit dem Träger 28 zusammenhalten. Die Bohrungen 30 im Träger 28 sind zur Befestigung des Federbandes 35 vorgesehen.

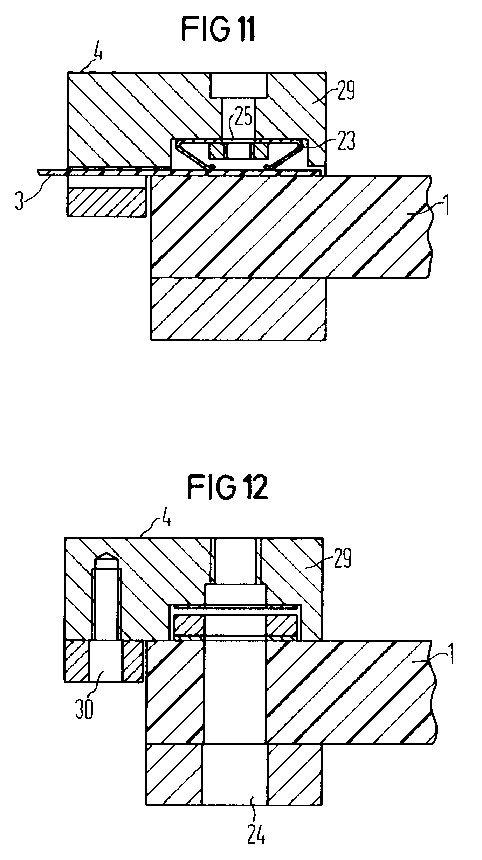

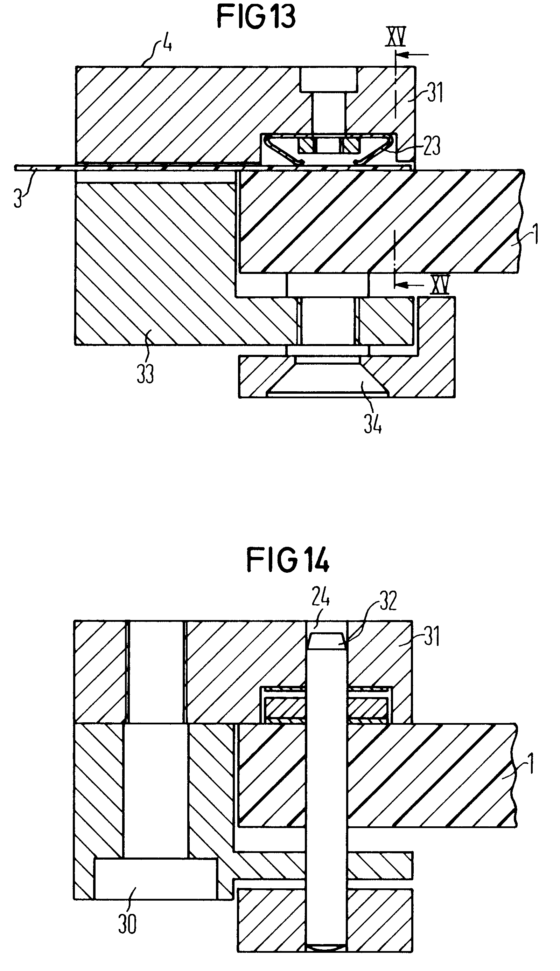

Eine Kontaktfedereinheit unter Verwendung eines zweireihigen Federbandes 26 ist im Längsschnitt in FIG 11 dargestellt. Dabei ist die trapezförmige Form der Feder 23 deutlich erkennbar. Die Kontaktfedereinheit ist so ausgeführt, daß soviele Einzelfedern wie Kontaktstellen zu einem Metallband zusammengefaßt und entsprechend den gewünschten Federeigenschaften ausgeformt sind. Das Federband stützt sich an dem Träger 29, der aus Metall bestehen kann, ab. Die Gegenkraft wird im vorliegenden Fall, wie aus FIG 12 ersichtlich, mit Hilfe von nicht dargestellten, in die Paßlöcher 24 einführbare Paßschrauben, die von der den Kontaktstellen abgewandten Seite gelöst werden können, aufgebracht oder wie in FIG 13 als Längsschnitt durch eine Kontaktfedereinheit dargestellt, durch einen bremssattelähnlichen Bügel 33 und dazugehörige Schrauben 34 zur Befestigung aufgebracht. Alle Teile besitzen Paßlöcher 24 mit entsprechender Genauigkeit, so daß der ganze Andruckverbinder 4 mit Paßstiften oder Paßschrauben über Löcher in den Leiterplatten zu den Kontaktflecken 7, 8 auf den starren Leiterplatten bei der Montage justiert werden kann. Durch Lösen der Befestigungsschrauben kann der Andruckverbinder 4 von der Leiterplatte gezogen werden. Die flexible Schaltung erlaubt Bewegungen der Leiterplatten zueinander.

Die Kontaktfedereinheit ist, wie aus dem Querschnitt durch die Schnittlinie 15 der FIG 13 dargestellt, zu ersehen ist, so ausgeführt, daß soviele Einzelfedern wie Kontaktstellen zu einem kammförmigen Metallband zusammengefaßt und entsprechend den gewünschten Federeigenschaften ausgeformt sind. Dabei ist erkennbar, daß die Federn 23 auf die isolierte Rückseite der zweiten Lage 10 und zwar jeweils an den Stellen, an denen sich Leiterbahnen befinden, einzeln aufdrücken und dadurch den Andruckkontakt verursachen.

Die Leiterbahnen auf der flexiblen Leiterplatte 3 sind an der Stelle, wo sie als Kontaktfinger benützt werden, erhaben ausgebildet, so daß beim Andrükken der flexiblen Schaltung auf die Leiterplatte in jedem Fall eine definierte und gasdichte Verbindung entsteht. Die erhabenen Konaktfinger sind jedoch für die Funktionsweise des Andruckverbinders nicht unbedingt notwendig. Sie erhöhen jedoch die Zuverlässigkeit des Kontakts. Der Kontakt zwischen der jeweiligen starren Leiterplatte 1, 2 und der flexiblen Leiterplatte 3 wird durch die Kraft der vorher beschriebenen Metallfedern 23, 27 hergestellt, der jeden einzelnen Kontaktfinger individuell und unabhängig von allen anderen Kontaktfingern auf den zugehörigen Kontaktfleck 7, 8 der starren Leiterplatte 1, 2 drückt und deren Federcharakteristik so eingestellt ist, daß alle Toleranzen ausgeglichen werden können. Die Einzelfeder drückt dabei durch die flexible Schaltung die Kontaktfinger, wie bereits vorstehend ausgeführt, auf den jeweils zugehörigen Kontaktfleck der jeweiligen starren Leiterplatte 1, 2.

Der beschriebene Andruckverbinder verwendet zur Herstellung der Verbindung zwischen zwei oder auch mehreren Leiterplatten eine flexible Leiterplatte, die im vorliegenden beschriebenen Fall zweilagig ist und den elektrischen Anforderungen bezüglich Wellenwiderstand, Übersprechen und Gleichstromwiderstand entsprechend ausgeführt ist. Das beschriebene Konzept erlaubt allerdings auch den Einsatz von einlagigen flexiblen Leiterplatten und Bandleitungen. Die flexible Schaltung ist außer im Bereich der Kontaktfinger vollständig mit Isolierfolie abgedeckt. Die Kontaktfinger auf der flexiblen Leiterplatte 3 und die Kontaktflecken 7, 8 auf den starren Leiterplatten 1, 2 sind mit einer Edelmetalloberfläche versehen und aus elektrischen Gründen, wie Wellenwiderstand und Übersprechen, in einem Signal/GND (Masseverhältnis) von 1:1 ausgeführt und angeordnet. Die gleiche Anordnung und Aufteilung gilt für die flexible Leiterplatte. Für niedrige Anforderungen an die elektrische Qualität der Verbindung sind auch andere Verhältnisse und Anordnungen möglich.

**Patentansprüche**

1.  Kontaktvorrichtung zur Herstellung einer Andruckkontaktverbindung zwischen starren und flexiblen Leiterplatten, **dadurch gekennzeichnet,** daß die starren Leiterplatten (1,2) Kontaktflecken (7,8) und die flexiblen Leiterplatten (3) Kontaktfinger (11,12,13,14) als Kontaktstellen für die Leiterbahnen der Leiterplatten (1,2,3) aufweisen, daß die Kontaktfinger (11,12,13,14) der flexiblen Leiterplatte (3) und die Kontaktflecken (7,8) der starren Leiterplatte (1,2) aufeinanderliegen, daß auf der Rückseite der flexiblen Leiterplatte ein in einem Träger (28,29,31) abgestütztes Federband (26,35) angeordnet ist, dessen in Abstand der Kontaktfinger (11,12,13,14) der flexiblen Leiterplatte (3) ausgeprägten Einzelfedern (23,25) Kontaktfinger (11,12,13,14) und Kontaktflecken (7,8) einzeln über die Isolationsschicht der flexiblen Leiterplatte (3) mit Hilfe von die Gegenkraft aufnehmenden Elemente (32,24) aufeinanderdrücken.

2.  Kontaktvorrichtung zur Herstellung einer Andruckkontaktverbindung zwischen starren und flexiblen Leiterplatten nach Anspruch 1, **dadurch gekennzeichnet,** daß die Leiterplatten und das Federband Paßlöcher (24) zum Einführen von Paßstiften (32) oder Paßschrauben enthalten.

3.  Kontaktvorrichtung zur Herstellung einer Andruckkontaktverbindug zwischen starren und flexiblen Leiterplatten nach Anspruch 2, **dadurch gekennzeichnet,** daß die Gegenkraft aufbringenden Elemente Paßschrauben sind.

4.  Kontaktvorrichtung zur Herstellung einer Andruckkontaktverbindung zwischen starren und flexiblen Leiterplatten nach Anspruch 2, **dadurch gekennzeichnet,** daß das die Gegenkraft aufbringende Element ein bremssattelähnlicher Bügel (33) ist, der mit einer Schraube (34) befestigt ist.

5.  Kontaktvorrichtung zur Herstellung einer Andruckkontaktverbindung zwischen starren und flexiblen Leiterplatten nach einem der vorhergehenden Ansprüche, **dadurch gekennzeichnet,** daß die flexible Leiterplatte (3) zweilagig ausgebildet ist und daß die signal- und die massepotentialführenden Leiterbahnen (18,16) der zweiten Lage (10) über getrennte Durchkontaktierungen (22,21) auf die erste Lage (9) durchkontaktiert sind, und daß die signal- und massepotentialführenden Leiterbahnen (11,12) der ersten Lage (9) von den Durchkontaktierungen (21,22) elektrisch getrennt sind.

6.  Kontaktvorrichtung zur Herstellung einer Andurckkontaktverbindung zwischen starren und flexiblen Leiterplatten nach einem der vorstehenden Ansprüche, **dadurch gekennzeichnet,** daß die Federn (23) des Federbandes (26) trapezförmig geformt sind, so daß sie ein zweiseitiges Konaktelement bilden.

7.  Kontaktvorrichtung zur Herstellung einer Andruckkontaktverbindung zwischen starren und flexiblen Leiterplatten nach einem der Ansprüche 1 bis 5, **dadurch gekennzeichnet,** daß das Federband (35) kammförmig ausgebildet ist, und daß es ein einreihiges Kontaktelement bildet, dessen Federn (27) schräg nach unten abgebogen sind.

8.  Kontaktvorrichtung zur Herstellung einer Andruckkontaktverbindung zwischen starren und flexiblen Leiterplatten nach Anspruch 7, **dadurch gekennzeichnet,** daß zwei einreihige Federbänder (35) im Träger (28) zu einem zweireihigen Kontaktelement vereinigt sind.

9.  Kontaktvorrichtung zur Herstellung einer Andurckkontaktverbindung zwischen starren und flexiblen Leiterplatten nach einem der vorhergehenden Ansprüche, **dadurch gekennzeichnet,** daß die Kontaktfinger (11,12,13,14) der flexiblen Leiterplatte erhaben sind.

# FIG 1

# FIG 2

# FIG 3

# FIG 4

## FIG 5

## FIG 6

EP 0 501 171 A2

FIG 7

FIG 8

## FIG 9

## FIG 10

## FIG 11

## FIG 12

## FIG 13

## FIG 14

# FIG 15